Europäisches Patentamt

European Patent Office

Office européen des brevets

(19)

(11) Numéro de publication: **0 167 800**

**A1**

(12)

# DEMANDE DE BREVET EUROPEEN

(21) Numéro de dépôt: **85106810.6**

(22) Date de dépôt: **03.06.85**

(51) Int. Cl.⁴: **G 04 B 37/22**
**C 23 C 14/02**

(30) Priorité: **07.06.84 CH 2781/84**

(43) Date de publication de la demande:
**15.01.86 Bulletin 86/3**

(84) Etats contractants désignés:
**DE FR GB**

(71) Demandeur: **Montres Rado S.A.**
**Bielstrasse 43**
**CH-2543 Lengnau b. Biel(CH)**

(72) Inventeur: **Loth, Eric**
**Tiefenmattweg 40**
**CH-2500 Bienne(CH)**

(74) Mandataire: **de Raemy, Jacques et al,**
**SMH Société Suisse de Microélectronique et**
**d'Horlogerie S.A. Département Brevets et Licences**
**Faubourg du Lac 6**
**CH-2501 Bienne(CH)**

(54) **Boîte de montre en métal dur portant un revêtement résistant.**

(57) La boîte de montre présente un corps de boîte en métal dur, de dureté supérieure à 1400 Vickers de préférence. Le corps de boîte est surmonté d'un revêtement à deux couches. La composition chimique des deux couches est identique et comporte la combinaison d'un métal et un élément dont le nombre atomique est inférieur à 9. La première couche est déposée par CVD et la seconde par PVD. Si le métal est du titane et l'élément de l'azote, on obtient sur un corps de boîte inrayable un revêtement dur, parfaitement adhérent et ayant la coloration de l'or.

EP 0 167 800 A1

Croydon Printing Company Ltd.

1

## BOITE DE MONTRE EN METAL DUR PORTANT UN REVETEMENT RESISTANT

La présente invention est relative à une boîte de montre comportant un corps de boîte surmonté d'un revêtement.

Si l'on veut donner à la matière brute d'une boîte de montre, par exemple de l'acier, un aspect à l'esthétique plaisante, on recouvrira cette boîte et au moins ses parties visibles d'un dépôt galvanique par exemple. C'est ainsi qu'on peut obtenir de façon connue une boîte chromée ou dorée. On sait que ces revêtements sont peu résistants à l'usure et qu'ils ne résistent généralement pas à l'abrasion.

Pour palier cet inconvénient, le document FR-A-2 425 210 (US-A-4.252.862) propose de recouvrir l'objet d'un revêtement de nitrure de titane (TiN) qui, en même temps qu'il est dur et résistant à l'abrasion, présente une surface externe de coloration proche de celle de l'or. Cependant, dans le document cité, on envisage le seul emploi du laiton ou de l'acier inoxydable comme corps principal de l'objet. Ces métaux présentent généralement une surface satinée et on s'aperçoit qu'après application du TiN, la surface de l'objet est extrêmement sensible aux marques de doigts qui y laissent des empreintes indélébiles. Pour éviter cet inconvénient le document cité propose alors de revêtir la couche de TiN par une couche d'or ou d'alliage d'or qui de surcroît améliore encore la ressemblance de coloration avec l'or. D'après les explications données dans le même document, la couche de TiN est appliquée par déposition physique en phase vapeur, procédé qui est plus connu sous l'appellation anglaise "Physical Vapor Deposition" et abrégé par PVD.

Il se trouve que si l'on applique l'enseignement du brevet français cité à un corps de boîte en métal dur dont la dureté Vickers dépasse les 600 $HV_1$ (par exemple au moins de l'acier trempé DIN 1.4125 ou du stellite) mais se situant de préférence aux environs des 1400 $HV_5$ (par exemple du carbure de Tungstène), on s'aperçoit que les doigts ne laissent plus d'empreintes indésirables puisque le corps de boîte présente une surface polie. Il ne serait donc plus nécessaire d'appliquer une couche d'or supplémentaire. Toutefois, on s'aperçoit que l'adhérence de la couche de TiN sur ce substrat en métal dur est mauvaise. Ceci est dû notamment au fait qu'il existe de fortes tensions entre la couche de TiN et son support, tensions qui peuvent être mises en évidence par une mesure de dureté Vickers où l'on constate souvent un éclatement de la couche de TiN lors de l'application du poinçon de mesure en forme de losange. Ce défaut de médiocre adhérence peut aussi être mis en évidence par le test de la lime (lime de dureté de 45 Rockwell avec trente lignes par centimètre).

Pour minimiser les tensions dont il a été question à l'alinéa ci-dessus, on pourrait, comme cela est connu, interposer entre le corps de boîte en métal dur et la couche de TiN une couche de titane (Ti). On enregistre alors une meilleure adhésion de la couche de TiN car les tensions indiquées sont absorbées par la sous-couche tendre de titane. Toutefois, à part le fait que la couche de TiN s'enlève tout de même assez facilement à cause de la faible dureté de la couche de titane ($< 300 \, HV_1$), la solution proposée perd beaucoup de son intérêt puisque le caractère inrayable du corps de boîte disparaît du fait de la présence du titane en sous-couche. Pour palier cet inconvénient on pourrait diminuer l'épaisseur de la couche de titane à moins de 0,2 μm. L'expérience a cependant montré qu'une couche si mince est extrêmement difficile à obtenir. Quoiqu'il en soit et comme on l'a mentionné le revêtement ne résiste pas au test de la lime.

En conclusion de ce qui vient d'être dit, toutes les méthodes connues à ce jour et consistant à déposer une couche de TiN par déposition physique en phase vapeur (PVD) sur du métal dur sont impropres à satisfaire au critère d'inrayabilité.

Poursuivant alors ses investigations dans le domaine dont il est question ici le demandeur a cherché à déposer une couche de nitrure de titane sur du métal dur, non plus par le procédé PVD, mais par dépositions chimiques en phase vapeur, procédé plus connu sous l'appellation anglaise "Chemical Vapor Deposition" et abrégé par CVD. Il a été possible alors d'obtenir une couche de TiN très adhérente au corps de boîte (liaison chimique) et satisfaisant au test de la lime dont il a été question plus haut. Toutefois, non seulement cette couche présente une coloration assez éloignée de celle de l'or, mais encore manque d'homogénéité quant à cette coloration.

C'est ainsi que pour remédier aux inconvénients cités la présente invention propose un corps de boîte de montre dont la dureté est supérieure à 600 $HV_1$ surmonté d'un revêtement comprenant une première couche composée d'une combinaison d'un métal et d'un élément dont le nombre atomique est inférieur à 9 et appliquée sur ledit corps de boîte par déposition chimique en phase vapeur (CVD) et une seconde couche de composition semblable à celle de la première couche et appliquée sur ladite première couche par déposition physique en phase vapeur (PVD).

Il a déjà été proposé, pour des outils servant à l'usinage de métaux tels des outils de coupe, de recouvrir un métal dur d'un double revêtement, le premier déposé par CVD et le second par PVD. Cela apparaît notamment dans le document DD 148 349. Toutefois, dans ce document, l'utilisation de la couche déposée par CVD n'a pas d'autre but que d'améliorer l'adhérence de la couche déposée par PVD sur le métal dur et le problème posé par la présente invention de proposer un revêtement de coloration uniforme et proche de celle de l'or ne se présente pas. Pour résoudre ce problème, il est par ailleurs nécessaire d'utiliser des couches CVD et PVD de composition semblable, ce qui n'est nullement décrit ni même suggéré dans le document cité.

On a encore proposé dans le document FR 2 302 350 un objet utilitaire tel un article de bijouterie muni d'une couche de revêtement en matériau dur en-dessous de laquelle se trouve une zone dure constituée de métaux et/ou de combinaisons métalliques dont la surface extérieure présente une dureté Vickers supérieure à 700. Cependant, aucun des nombreux exemples cités dans ce document ne laissent penser à la double couche objet de la présente invention. Ici également s'il est question d'adhérence, il n'est nullement fait mention du problème esthétique qui se pose d'obtenir un objet à couleur parfaitement homogène.

L'invention sera mieux comprise maintenant à la lumière de la description qui suit.

Comme on l'a déjà dit la boîte de montre comprend d'abord un corps de boîte massif constitué par une matière dure dont la dureté est d'au moins 600 $HV_1$. De préférence ce sera une matière inrayable dont la dureté est de l'ordre de ou supérieure à 1400 $HV_5$. Cette

matière, qui peut comprendre du carbure de titane (TiC), du carbure de tungstène (WC) ou une céramique, est lisse et polie. Elle est obtenue par des moyens connus de l'état de la technique et rappelés par exemple dans le brevet US-A-3 242 664.

Selon l'invention, le corps de boîte ainsi formé est recouvert d'une première couche par déposition chimique en phase vapeur (CVD). Cette opération connue en soi peut être menée à bien de la façon suivante: on introduit le corps de boîte dans une enceinte. On diminue la pression à l'intérieur de l'enceinte après quoi on chauffe à haute température (900 à 1100° C). On fait circuler alors un gaz contenant du $TiCl_4$ + $H_2$ qui réagit avec l'azote contenu dans l'athmosphère de l'enceinte. Le gaz précipite à la surface de la pièce à recouvrir et l'azote se combine au titane pour former la première couche de TiN. De la durée du traitement va dépendre l'épaisseur de la couche atteinte. Dans un exemple pratique la première couche aura une épaisseur inférieure à 3 µm. Comme on l'a déjà expliqué cette première couche adhère parfaitement sur le métal dur. Sa couleur par contre est assez éloignée de la couleur de l'or.

Toujours selon l'invention, le corps de boîte ainsi revêtu est recouvert ensuite d'une seconde couche par déposition physique en phase vapeur (PVD). On connaît plusieurs méthodes pour procéder à ce dépôt. L'une de celles-ci consiste à introduire la pièce à traiter dans une enceinte contenant une cible de titane ou de nitrure de titane.

On crée ensuite dans l'enceinte un vide poussé ($\sim 10^{-5}$ Torr) par pompage. Puis, la pièce subit un décapage ionique à haute tension (1 KV). On introduit alors dans l'enceinte de l'argon et de l'azote puis on crée une décharge électroluminescente qui ionise l'argon, d'où naissance d'un plasma. Ce plasma arrache alors des particules à la cible qui vont se déposer sous forme de nitrure de titane sur la pièce à recouvrir. Ici également l'épaisseur de la couche va dépendre de la durée de l'opération. Dans un exemple pratique on limitera l'épaisseur de la couche à 1µm. Comme on l'a expliqué plus haut, la couleur finale obtenue par ce procédé est parfaitement maîtrisable et si le second dépôt est du TiN, on peut atteindre une couleur très proche de celle de l'or.

Ce qui vient d'être dit peut être mis en évidence par des mesures de la réflexion optique des pièces soumises à examen, où la réflectivité R en pourcent (%) est représentée en fonction de la longueur d'onde de la lumière λ en nanomètre (nm). Pour l'or fin le quotient de la réflectivité à 600 nm (R600) par rapport à la réflectivité à 450 nm (R450) est de 2,5. Mesuré dans les mêmes conditions ce quotient vaut 3,9 pour une couche de TiN déposée par CVD (ce qui indique un jaune très soutenu) alors que ledit quotient vaut 2,6 pour la couche de TiN déposée par PVD (ce qui indique une coloration très proche de celle de l'or). Ces mesures répétées en divers points de la surface en examen montrent encore une dispersion importante pour la couche déposée par CVD alors que cette dispersion est minime pour la couche déposée par PVD. D'ailleurs une simple observation visuelle vient confirmer les résultats de ces mesures.

On comprendra aussi que la première couche pourra être déposée sans précaution spéciale pour obtenir un revêtement qui soit le même pour toutes les pièces. Par contre en modifiant les paramètres présidant au dépôt de la seconde couche, on pourra obtenir des résultats différents suivant la coloration finale désirée, par exemple jaune pâle ou jaune or 24 carats.

On mentionnera encore que l'adhérence du TiN déposé par PVD sur du TiN déposé par CVD est excellente et en tout cas meilleure que l'adhérence du TiN déposé par PVD directement sur un métal dur. De plus, si d'aventure la couche de TiN déposée par PVD venait à être partiellement enlevée, il resterait la sous-couche de TiN déposée par CVD qui, on l'a dit, se rapproche tant soit peu de la couleur de l'or.

Si le but préféré de la présente invention est d'obtenir un revêtement de boîte de montre le plus proche possible de la coloration de l'or, il serait aussi possible d'obtenir d'autres colorations. Par exemple on obtiendra une couleur blanche en déposant selon l'invention deux couches de carbure de titane (TiC) ou de carbure de tungstène (WC). Le bleu pourrait être obtenu de la même façon par double dépôt d'oxyde de titane (TiO$_2$). Un dépôt transparent pourrait aussi être obtenu par double dépôt d'oxyde d'aluminium (Al$_2$O$_3$). Plus généralement on se rend compte que chacune des couches est composée d'une combinaison d'un métal (Al, Ti, W) et d'un élément dont le nombre atomique est inférieur à 9 (N, C, O).

6  ·0167800·

## REVENDICATIONS

1. Boîte de montre comportant un corps de boîte surmonté d'un revêtement, caractérisée par le fait que la dureté du corps de boîte est supérieure à 600 $HV_1$ et que le revêtement comprend une première couche composée de la combinaison d'un métal et d'un élément dont le nombre atomique est inférieur à 9 et appliquée sur ledit corps de boîte par déposition chimique en phase vapeur (CVD) et une seconde couche de composition semblable à celle de la première couche et appliquée sur ladite première couche par déposition physique en phase vapeur (PVD).

2. Boîte de montre selon la revendication 1, caractérisée par le fait que le corps de boîte est en matière inrayable présentant une dureté supérieure à 1400 $HV_5$.

3. Boîte de montre selon la revendication 2, caractérisée par le fait que les première et deuxième couches sont du nitrure de titane (TiN).

4. Boîte de montre selon la revendication 2, caractérisée par le fait que les première et seconde couches sont du carbure de titane (TiC).

5. Boîte de montre selon la revendication 2, caractérisée par le fait que les première et seconde couches sont en oxyde métallique.

## DOCUMENTS CONSIDERES COMME PERTINENTS

| Catégorie | Citation du document avec indication. en cas de besoin, des parties pertinentes | Revendication concernee | CLASSEMENT DE LA DEMANDE (Int Cl 4) |
|---|---|---|---|
| D,Y | DD-A- 148 349 (VEB WERKZEUGMASCHINENKOMBINAT) <br> * Page 3, ligne 11 - page 4, ligne 6 * | 1 | G 04 B 37/22 <br> C 23 C 14/02 |
| D,Y | FR-A-2 302 350 (METALLWERK PLANSEE A.G.) <br> * Page 2, lignes 23-33; page 3, ligne 36 - page 4, ligne 17 * | 1 | |
| A | | 3-5 | |
| A | CH-A- 2 962 (SINGER)(A.D.1974) <br> * Colonne 3, lignes 23-47 * | 3-5 | |
| A | METALLOBERFLÄCHE, volume 37, no. 7, juillet 1983, pages 279-285, Munich, DE; W.D. MÜNZ et al.: "Herstellung harter dekorativer goldfarbener Titannitridschichten mittels Hochleistungskatodenzerstäubung" | 1,3 | DOMAINES TECHNIQUES RECHERCHES (Int. Cl.4) <br><br> G 04 B <br> G 04 D <br> C 23 C |

Le présent rapport de recherche a été établi pour toutes les revendications

| Lieu de la recherche <br> LA HAYE | Date d'achèvement de la recherche <br> 10-09-1985 | Examinateur <br> PINEAU A.C. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82